# EUROPEAN PATENT APPLICATION

(11) **EP 3 537 208 A1**
(43) Date of publication of application: **11.09.2019**
(21) Application number: 17855048.9
(22) Date of filing: 01.10.2017
(51) Int. Cl.: G02F 1/13357

(54) **LIGHT SOURCE ASSEMBLY, DISPLAY DEVICE, AND MANUFACTURING METHOD FOR LIGHT SOURCE ASSEMBLY**

(30) Priority: 30.09.2016 CN 201610878541; 21.01.2017 CN 201710052402; 21.01.2017 CN 201710045498
(71) Applicant: Shenzhen LT Optoelectronics Co., Ltd., Shenzhen, Guangdong 518000 (CN)
(72) Inventor: WANG, Lei, Shenzhen Guangdong 518000 (CN)
(74) Representative: Zaboliene, Reda
(86) International application number: PCT/CN2017/105194
(87) International publication number: WO 2018/059598

(57) **Abstract**

A light source assembly includes a base, a plurality of LED chips disposed in an array on the base, and a fluorescent layer covering the base and the plurality of LED chips; wherein light from the plurality of chips is homogenized to form a light emitting surface by a same fluorescent layer; an area of the light emitting surface being equal to an area of one side of the fluorescent layer, far away of the plurality of LED chips; and the ratio of the area of the light emitting surface to an area of a side of the base, on which the plurality of LED chips being disposed, being 1:0.9 to 1:1.1. Compared to traditional laterally-oriented light-emitting light source assemblies or vertically-oriented light-emitting assemblies, the light source assembly and the display device of the present invention can be provided with a thin border or even no border and still provide a superior light-emitting effect. Unlike with existing mainstream OLED screens, the present invention may be fitted on traditional LCD screens, providing same with a backlight assembly that uniformly emits light, and that is stable and consumes little power.

## Description

### FIELD OF THE INVENTION

The invention relates generally to the field of LED display, and in particular, to a light source assembly, a display device and a manufacturing method of a light source assembly.

### BACKGROUND OF THE INVENTION

LED (Light Emitting Diode) is a common solid light source, which has the characteristics of long life, high stability, energy saving and environmental protection. Existing LED display components usually encapsulate several LED chips on a circuit board. Whether side-lighting or direct-down lighting are used, the existing LED light source has a enclosure or enclosure structure to make the fluorescent glue formed on the LED chip by coating. However, the preparation process often needs to be in place. This paper describes the setting of light reflection area at the edge of the LED light source, so that the light effect of the LED light source is not uniform and the structure of reflector board is needed to achieve uniform light effect. The existing backlight for display components has a large overall thickness, which is difficult to meet the needs of people for the thinning of digital products.

Furthermore, with the increasing demand for screen display of digital products, OLED (Organic Light-Emitting Diode) is the main display component of the current large-screen or full-screen mobile phones. However, due to the limitations of OLED technology itself, the production capacity is insufficient and the cost is expensive, which is not conducive to the overall promotion of OLED display components. Due to the limitation of the structure of the existing traditional backlight, it is difficult to remove the black frame of the light source to achieve narrow and no borders display. Therefore, the promotion of large-screen mobile phones or full-screen mobile phones is greatly limited.

With the increasing demand for diversification of electronic devices with display components in the market, the existing LED light source technology has been unable to meet the market demand. Therefore, it is urgent to provide a new LED light-emitting technology to solve the existing LED light source.

### SUMMARY OF THE INVENTION

In order to overcome the difficulty of realizing full screen and lightening of the display devices, the present invention provides a light source assembly, a display device and a manufacturing method of a light source assembly.

In one aspect, A light source assembly, has a base, a plurality of LED chips disposed in an array on the base, and a fluorescent layer covering the base and the plurality of LED chips; wherein light from the plurality of chips is homogenized to form a light emitting surface by a same fluorescent layer; an area of the light emitting surface being equal to an area of one side of the fluorescent layer, far away of the plurality of LED chips; and the ratio of the area of the light emitting surface to an area of a side of the base, on which the plurality of LED chips being disposed, being 1:0.9 to 1:1.1.

Preferably, the ratio of the area of the luminous surface of the fluorescent layer to the area of one side of the carrier carrying the LED chip is 1:1.

Preferably, one to thirteen LED chips are arranged below each square millimeter corresponding to the fluorescent layer.

Preferably, the distance between two adjacent LED chips is 0.01mm-1mm, the length of the chip is 0.01mm-1mm, and the width of the chip is 0.01mm-0.5mm. The thickness of the light source assembly is 0.01mm-0.6mm.

Preferably, the carrier is provided with a plurality of pad patterns and a plurality of wires on one side of the LED chip, the positive and negative poles of the LED chip are respectively welded on two pad patterns adjacent to each other, and the connection of the wires or all of the pad patterns, and the positive projection area of a single LED chip is larger than or equal to two corresponding to the LED chip Area occupied by solder pad pattern.

Preferably, one opposite side of the carrier and the LED chip, there are a plurality of pins for connecting with the external circuit, and the pins are electrically connected with the LED chip.

Preferably, the carrier comprises two overlapping layers of film, and a conductive layer is arranged between the two layers of film. The conductive layer comprises a plurality of pad patterns, which are electrically connected through wires, a plurality of windows are arranged on one layer of film to expose the corresponding pad patterns, and the positive and negative poles of the LED chip correspond to tin soldering, and the light source assembly also includes a fluorescent layer which fills the gap between the LED chips and bases all the LED chips.

Preferably, the light source assembly as defined in claim 1, wherein the film layer is a flexible material.

Preferably, all pad patterns and wires are arranged in the orthographic projection area of the fluorescent layer.

Preferably, the carrier is provided with a reflecting layer above one side of the LED chip and between the fluorescent layers. The reflecting layer is provided with multiple windows, and the LED chip is arranged in the window.

Preferably, the light source assembly further comprises a white edge formed on the carrier and arranged around the fluorescent layer; the peripheral of the white edge is identical with the peripheral of the carrier; and the thickness of the white edge is 0.001 mm-0.1 mm.

Preferably, a microlens layer is directly attached to the fluorescent layer, and a plurality of microlenses are arranged on the microlens layer corresponding to the LED chip.

In another aspect, a display device has a display element and a light source assembly, the light source assembly has a base, a plurality of LED chips disposed in an array on the base, and a fluorescent layer covering the base and the plurality of LED chips; wherein light from the plurality of chips is homogenized to form a light emitting surface by a same fluorescent layer; an area of the light emitting surface being equal to an area of one side of the fluorescent layer, far away of the plurality of LED chips; and the ratio of the area of the light emitting surface to an area of a side of the base, on which the plurality of LED chips being disposed, being 1:0.9 to 1:1.1.

In another aspect, a manufacturing method for light source assembly, has providing a base and forming a conductive circuit; forming solder spots on corresponding positions of the conductive circuit; disposing the LED chips on the corresponding solder spots, positioning a positive pole and a negative pole of each LED chip on two different circuit patterns; positioning the LED chip on the base by reflow soldering method; and covering a prefabricated fluorescent layer on the plurality of LED chips and getting the needed light source assembly.

Compared with the prior arts, the light source assembly, the display device and the method of manufacturing the light source assembly provided by the present invention have the following advantage:
The invention provides a display device, which provides a prefabricated fluorescent layer covering the LED chips and the base. The plurality of LED chips are defined as a plurality of zones, and the LED chips in the plurality of zones are driven and controlled by the driving circuit for displaying images. The lights emitted by the plurality of LED chips are homogenized by the same fluorescent layer and form a luminous surface. In the present invention, the LED chips can display the image directly. The display device can be used as an alternative to OLED display device for providing a solution with high feasibility, low cost and high yield for obtaining large screen and lightweight display device.

### BRIEF DESCRIPTION OF THE DRAWINGS

Fig. 1 is an exploded perspective view of a light source assembly of the first embodiment according to the present invention.
FIG. 2A is a view showing luminous effect of two adjacent LED chips in the light source assembly of the first embodiment according to the present invention.
FIG. 2B is a view showing a layer structure of the bases, an LED chips and a reflection film in the light source assembly according to the present invention.
Fig. 3 is a schematic diagram showing a structure of a first conductive layer and a second conductive layer formed on the base in the light source assembly of the first embodiment.
Fig. 4A is a plane diagram of the first conductive layer shown in Fig. 3.
Fig. 4B is an enlarged diagram shown at part C of Fig. 4A.
Fig. 4C is a schematic diagram showing a structure of LED chips soldering on the welding pad patterns, setting along one row, in Fig. 4B.
Fig. 5 is a plane schematic diagram of the second conductive layer of the light source assembly according to the present invention.
FIG. 6A is a plan schematic diagram of a deformation of the first conductive layer shown in FIG. 3.
FIG. 6B is a schematic a simplified circuit diagram of the first conductive layer shown in FIG. 6A.
FIG. 6C is an enlarged diagram shown at part D in FIG. 6A.
FIG. 7A is a schematic diagram showing a layer structure of the light source assembly shown in FIG. 1.
FIG. 7B is an enlarged diagram at part E in FIG. 7A.
FIG. 8A is a schematic diagram showing a light source assembly of the of the second embodiment according to the present invention.
FIG. 8B is a schematic diagram showing a layer structure of a microlens layer in the light source assembly.
FIG. 9A is a schematic diagram showing a white edge in the light source assembly of the second embodiment.
FIG. 9B is an enlarged diagram showing part F shown in FIG. 9A.
Fig. 10A is a layer structure diagram of a base of the light source assembly provided in the second embodiment of the present invention.
Fig. 10B is a schematic diagram showing a series of wilding pad patterns fixed to the plurality of LED chips as shown in Fig. 10A.
Fig. 10C is a layer structure diagram of the light source assembly provided in the second embodiment according to the present invention.
FIG. 10D is a schematic diagram of the layer structure of a single pad pattern.
Fig. 11A is a schematic diagram showing a layer structure of the display device of a third embodiment according to the present invention.
Fig. 11B is a block diagram of a driving element and a power element of the display device provided in the third embodiment according to the present invention.
Fig. 12 is a schematic diagram of an electronic device of a fourth embodiment according to the present invention.
FIG. 13 is a schematic diagram showing a bending state of a light source assembly in the electronic device shown in FIG. 12.
Fig. 14A is a perspective view of the display device provided in the fifth embodiment of the present invention.
Fig. 14B is a schematic diagram showing a layer structure of a fluorescent layer shown in Fig. 14A.
FIG. 14C is a schematic diagram showing a plurality of pixels in the display device shown in FIG. 14A.
Fig. 14D is a schematic view of the display device of FIG. 14A.
Fig. 15 is a schematic diagram of a wearing device provided in the sixth embodiment of the present invention.
FIG. 16 is a flowchart of a manufacturing method of a light source assembly provided in the seventh embodiment of the present invention.
FIG. 17 is a flow chart of step V101 in FIG. 16.
FIG. 18 is a flow chart of step V105 in FIG. 16.
Fig. 19 is a schematic diagram showing a change of a fluorescent film shown in FIG. 18, after a first and secondary hot pressing processes.
FIG. 20 is a flowchart of the manufacturing method of a light source assembly provided in the eighth embodiment of the present invention.

### DETAILED DESCRIPTION OF THE INVENTION

The invention will be described with reference to the accompanying drawings and the specifications. These and/or other aspects and advantages of the invention will become apparent and more readily appreciated from the following description of the embodiments, taken in conjunction with the accompanying drawings.

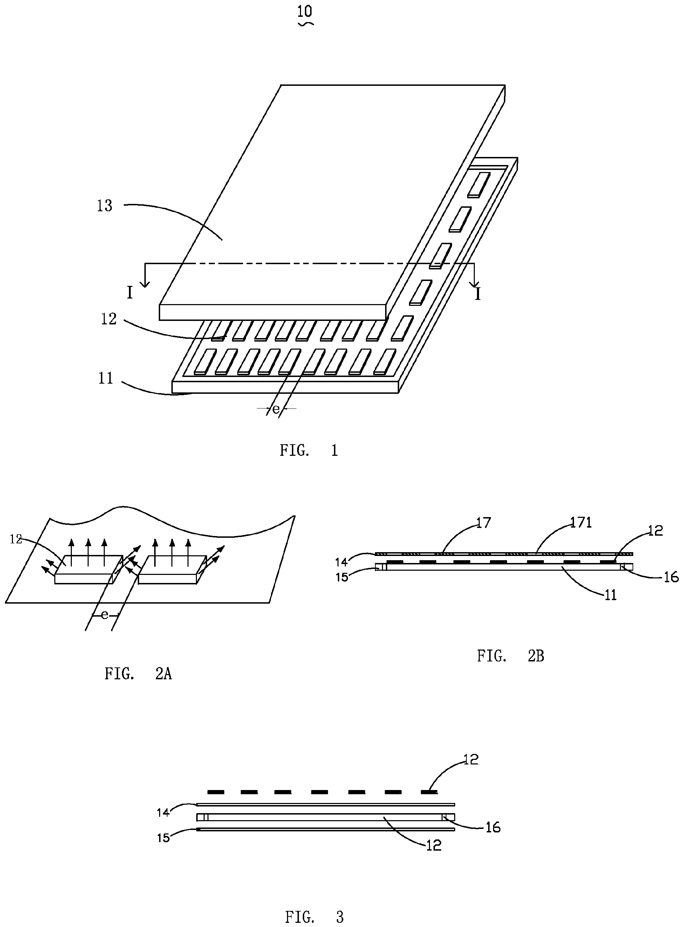

Referring to Fig. 1, a first embodiment of the present invention provides a light source assembly 10. The light source assembly 10 includes a base 11 and a plurality of LED chips 12 evenly arranged above the base 11. The light source assembly 10 further includes an uniform light layer 11, and a plurality of LED chips 12 are provided with the same uniform light layer 13. The light emitted by the LED chip 12 enters the uniform layer 13 directly for scattering, forming a luminous surface, being continuous and uniform. The area of the luminous surface is equal to that of a side of the uniform layer 13 far from the LED chips. The area ratio of the luminous surface to the side of the base 11 carrying the LED chips 12 is 1:(0.9-1.1). In a better embodiment, the area ratio of the luminous surface to the side of the base 11 carrying the LED chip 12 is 1:1. In the present invention, the uniform layer 13 bases a total surface of the base 11, and better, the area of the uniform layer 13 is same as that of the base 11, that is, the periphery of the base 11 is same as that of the uniform layer 13.

In order to make the light source assembly 10 have better luminous effect, one to thirteen LED chips 12 can be set at each square millimeter under the uniform layer 13. The words "up" and "down" mentioned herein and hereinafter are not limited by the present invention, but are only relative to the directions of the drawings. Optimally, one to five LED chips, five to nine LED chips or eight to fifteen LED chips can be set at each square millimeter under the uniform layer 13. Specifically, thirteen LED chips, twelve LED chips, eleven LED chips, ten LED chips, nine LED chips, eight LED chips, seven LED chips, five LED chips, three LED chips, two LED chips or one LED chips can be set at each square millimeter under the corresponding uniform layer 13.

In the first embodiment, the shape of the LED chip 12 can be strip, circular, square, etc. When the LED chip 12 is strip-shaped, the length of the LED chip 12 is 0.01-1 mm, and the width of the LED chip 12 is 0.01-0.5 mm. Preferably, the length of the LED chip 12 is 0.01 mm, 0.015 mm, 0.127 mm, 0.2 mm, 0.34 mm, 0.51 mm, 0.6 mm, 0.9 mm, 0.97 mm or 1 mm. The width of the LED chip 12 is 0.01 mm, 0.015 mm, 0.127 mm, 0.2 mm, 0.34 mm or 0.5 mm. Optimally, the length of the LED chip 12 is 0.228 mm and the width of the LED chip 12 is 0.127 mm.

When the LED chip 12 is circular, the diameter of the LED chip 12 is 0.01mm-0.75mm. Better, the diameter of the LED chip 12 can be further 0.01mm-0.01mm, 0.01mm-0.03mm, 0.03mm-0.07mm, 0.07mm-0.12mm, 0.11mm-0.2mm, 0.2mm-0.5mm or 0.55mm-0.75mm. Specific address, the maximum size of the LED chip 12 is 0.006mm, 0.08mm, 0.01mm, 0.013mm, 0.03mm, 0.05mm, 0.07mm, 0.091mm, 0.1mm, 0.11mm, 0.15mm, 0.18mm, 0.31mm, 0.45mm, 0.56mm or 0.75mm.

Furthermore, in the first embodiment, in a long strip shaped light source component 10, in order to make the light source assembly 10 have a better luminous effects, the LED chip 12 generally chooses a long strip shape to obtain a larger luminous surface. A long side of the LED chip 12 corresponds to a long side of the light source assembly 10, and a short side of the LED chip 12 corresponds to a short side of the light source assembly 10.

In order to improve the luminous uniformity of the multiple LED chips 12 under the uniform layer 13, as shown in Figure 2A, a single LED chip 12 has five luminous surfaces, and the luminous angle is optimized to be 140°C -150°C . The thickness of the LED chip 12 is 0.01mm-0.5mm. In a better embodiment, the thickness of the LED chip 12 is 0.01mm, 0.0254mm, 0.03mm or 0.5mm.

In order to make the light between the two adjacent LED chips 12 uniform, the distance between the adjacent LED chips 12 can be further limited. In combination with Fig. 1 and Fig. 2, a space between two adjacent LED chips 12 is 0.01mm-0.75mm. Preferably, the space between two adjacent LED chips 12 can be 0.01mm-0.025mm, 0.025mm-0.0.037mm, 0.037mm-0.052mm, 0.052mm-0.09mm, 0.09mm-0.14mm, 0.14mm-0.31mm or 0.31mm-0.75mm. Further, the space can be selected as any of the values of 0.01mm, 0.07mm, 0.08mm, 0.19 mm, 0.251 mm, 0.31 mm or 0.75 mm. Further, in order to obtain better luminescence effect, in some specific embodiments of the present invention, the plurality of said LED chips 12 are equally spaced. In the first embodiment, the setting of space can effectively improve the luminous uniformity of the light source assembly 10.

As shown in Fig. 2B, in order to enhance the luminous effect of the light source assembly 10, when the distribution distance of the LED chip 12 is large, a reflection layer 17 can be arranged above the base 11 and between the uniform layer 13. The reflection layer 17 is laid on one side of the base 11 with the LED chip 12. The reflection layer 17 has a plurality of windows 171, corresponding to the numbers and positions of the LED chips 12, which is used to expose the LED chips 12 and provide reflection for the LED chips 12, for reducing the use of the LED chips 12, and at the same time obtain better uniformity effect and luminous brightness.

In the present invention, the reflecting layer 17 can be an aluminum foil reflecting film and a silver reflecting film. The thickness of the reflecting layer 17 is not limited. When the reflecting layer 17 is added, the light efficiency of the light source assembly 10 can be increased by 1-30% on the original basis.

In order to make the adhesion between the reflecting layer 17, the base 11 and the uniform layer 13 closer, an adhesive layer can be set between the reflecting layer 17, the base 11 and the uniform layer 13 (not shown in the drawings).

In the present invention, by adding the reflective film 17, the light efficiency of the light source assembly 10 can be further improved on the basis of having the same numbers and the same arrangements of the LED chips 12.

In the present invention, the material of the base 11 can be copper, aluminum and other metal and alloy carriers, such as stainless steel, brass, etc. or flexible plastic carriers, such as epoxy glass fiber board, polyether ether ketone, polyimide, polycarbonate polycarbonate, polyethylene terephthalate, polyethylene succinate and polymethyl. Materials such as methyl acrylate, polyvinyl chloride, polypropylene, polycarbonate, polyaryl ester, polyethersulfone, polyethylene naphthalate and any combination thereof.

The base 11 can be a single-layer structure or a double-layer structure. When the base 11 is a double-layer structure, the base 11 is preferred to be formed by the pressing of a double-layer films, and the main surfaces of the two films are respectively formed with a circuit for welding the LED chip 12 and a circuit for connecting with the external circuit.

In the present invention, the carrier 11 adopts a double-layer structure, in particular a double-layer film laminated, which can further reduce the thickness of the carrier 11. Further, by forming the required conductive lines on the two thin films respectively, and then pressing the film, the thickness of the carrier 11 can be guaranteed to be thinner and further improved. One step is to ensure the solidity of LED chip welding and the stability of circuit connection.

When the carrier 11 is formed by pressing a double-layer polyimide film and forming a conductive circuit on the surface of the polyimide film, the LED chip is directly welded on the FPC.

In order to make the overall size of the light source assembly 10 lighter and thinner to meet the product requirements of the lighter and thinner electronic equipment, in some preferred embodiments of the invention, the thickness of the carrier 11 is 0.01mm-0.4mm, and preferably, the thickness F of the carrier 11 is 0.06mm-0.5mm. Preferably, the thickness of the carrier 11 can also be 0.06mm-0.09mm, 0.09mm-0.2mm, 0.19mm-0.2mm, 0.1mm-0.3mm and 0.29mm-0.4mm. Further, the thickness F of the carrier 11 can be specified as 0.06mm, 0.07mm, 0.09mm, 0.17mm, 0.2mm, 0.21mm, 0.29mm or 0.4mm.

In this embodiment, in some embodiments of the invention, the surface light source having a continuous luminous surface is arbitrarily divided into four regions and five regions. Understandably, it can be divided into two regions, three regions, six regions and so on, and the average luminous intensity between them. In some of the best embodiments of the present invention, the ratio of luminous intensity between any two regions of the surface light source with a continuous luminous surface is further 1:1.

Compared with the prior art, the light emitted by the light source unit 10 provided in the present embodiment has higher light efficiency and light utilization ratio, and the luminous intensity is more uniform than that of the existing direct-down surface light source and the side-emitting surface light source.

Please continue to refer to Figure 3. In the present invention, one side of the carrier 11 equipped with an LED chip 12 is the first surface 1101 of the carrier 11, while the other side relative to the first surface 1101 is defined as the second surface 1102. A first conductive layer 14 is formed on the first surface 1101 of carrier 11 and a second conductive layer 15 is formed on the first surface 1102 of carrier 11. The first conductive layer 14 and the second conductive layer 15 can be formed either by etching or plating on the corresponding surface of carrier 11 or by laminating. Unrestricted.

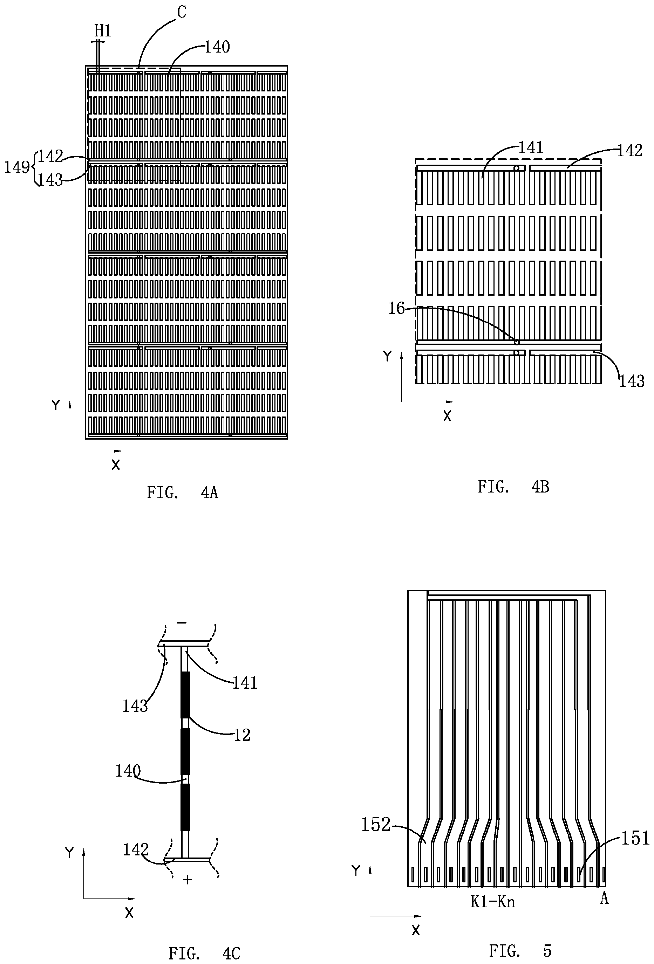

As shown in Fig. 4A, the first conducting layer 14 includes a plurality of groups of wires 149 of the pad pattern group 140 and the connection connection connection said pad pattern group 140, of which, preferably, the plurality of pad pattern groups 140 and the plurality of groups of wires 149 are co-planar settings. And a number of groups of wires 149 are set in parallel.

Each group of conductors 149 includes many first conductor 142 and one second conductor 143, among which many first conductors 142 are arranged at the same linear interval, and many first conductors 142 and one second conductor 143 are arranged in parallel. A plurality of pad pattern groups 140 are arranged in parallel between the first conductor 142 and the second conductor 143. Refer to Figures 4B and 4C. Each set of pad patterns 140 consists of at least three pad patterns 141 arranged at intervals along the same straight line, preferably with equidistant distribution between adjacent pad patterns 141. In the present invention, preferably, the area of the pad pattern 141 is (0.01-0.1) mm^{∗}(0.01-0.1) mm, and the area of the pad pattern 141 can be specified as 0.05 mm^{∗}0.05 mm or 0.1 mm^{∗}0.1 mm.

In the present invention, a plurality of pad patterns 141 are arranged in rows or arrays.

In the present invention, as shown in Fig. 4B, the positive and negative poles of an LED chip 12 can be respectively welded on two pad patterns 141 adjacent to each other, in which the width of the LED chip 12 is larger than the width of any of the pad patterns 141, and the positive projection area of the LED chip 12 is larger than or equal to the two pad patterns corresponding to the LED chip. The area of the area occupied.

In the present invention, the first conductor 142 or the second conductor 143 are connected with a pad pattern 141. As shown in Figure 4B, there are four pad patterns 141 distributed equidistantly between the first conductor 142 and the second conductor 143. One LED chip 12 is welded between two adjacent pad patterns 141, and a series circuit is formed between the LED chip 12 and the pad pattern 141.

In some more embodiments of the invention, the reflecting layer 17 can be specifically set above the pad pattern 141, the window 171 set on the reflecting layer 17, and the LED chip 12 can be set within the window 171.

Continuing as shown in Figures 4A and 4B, the first wire 142 divides the pad pattern 141 into multiple LED chip areas, and the second wire 143 electrically connects multiple LED chip areas in series or in parallel. Specifically, after the LED chip 12 is soldered to the pad pattern 141 by solder paste, the first conductor 141 further divides the LED chip 12 into multiple LED chip regions; the second conductor 143 electrically connects multiple LED chip regions in series or in parallel, thereby realizing the electrical control of the LED chip 12 in a partition.

As shown in Fig. 4A and Fig. 4B, the first wire 142 is connected to 11 groups of welding patterns 140 at the same time. Each welding pattern 140 includes four welding patterns 141 with equal spacing along the Y direction. As shown in Figure 4C, one LED chip 12 is welded between two adjacent welding patterns 141. It can be seen that an LED chip area separated by the first lead 142 may include 33 LED chips 12. Among them, the LED chips arranged in Y direction are connected in series, while the LED chips arranged in X direction are connected in parallel. The circuit connection relationship of the pad pattern 141 connected with the first conductor 142 and the second conductor 143 is as follows: one end of the pad pattern 141 connects the first conductor 142, the other end connects the positive pole of the LED chip 12; one end of the pad pattern 141 connects the second conductor 143, and the other end connects the negative pole of the LED chip 12.

In the present invention, as shown in figs. 4B and 4C, the distance between two pad patterns 141 for welding the same LED chip is HI 0.01mm-1mm, preferably the distance HI can be further 0.01mm-0.1mm, 0.01mm-0.5mm, 0.1-0.6mm, 0.2-0.9mm or 0.8-1mm, etc. Specifically, the spacing HI can be 0.01 mm, 0.025 mm, 0.04 mm, 0.1 mm, 0.3 mm, 0.5 mm, 0.9 mm or 1 mm.

In order to place the LED chip 12 in the unit area, the width of the first conductor 142 and the second conductor 143 can be further limited to 0.01mm-0.5mm, while the distance between the adjacent first conductor 142 and the second conductor 143 is 0.01mm-1mm.

Among them, the width of the first conductor 142 and the second conductor 143 can be further 0.01mm-0.05mm, 0.05mm-0.12mm, 0.16mm-0.3mm, 0.25mm-0.4mm or 0.4mm-0.5mm. Specifically, the line width can be specified as 0.01mm, 0.03mm, 0.05mm, 0.09mm, 0.12mm, 0.16mm, 0.19mm, 0.25mm, 0.4mm or 0.5mm. The distance between the adjacent first conductor 142 and the second conductor 143 can be 0.01mm-0.05mm, 0.05mm-0.08mm, 0.16mm-0.3mm, 0.25mm-0.8mm or 0.8mm. Specifically, the line spacing can be specified as 0.01mm, 0.03mm, 0.15mm, 0.59mm, 0.67mm, 0.76mm, 0.89mm, 0.95mm or 1mm.

Referring to Fig. 5, the second conductive layer 15 further comprises a plurality of pins 151 connected with an external circuit and a conductive pattern 152 extended from the pin 151, which is co-planar between the conductive pattern 152 and the pin 151. That is, the pin 151 is arranged on the surface baseed by the non-uniform layer, and the pin 151 can be electrically connected with the LED chip. Among them, the specific shape of the conductive pattern 152 is not limited.

Preferably, the number of pins 151 is the same as the number of partitions in the LED chip area. The pins 151 are better arranged in rows on the same side of the carrier, which simplifies the circuit connection relationship of the light source assembly 10, thereby making the light source assembly 10 lighter.

The pin 151 can be further divided into positive pin (unlabeled) and negative pin (unlabeled), in which the distribution and number of positive and negative pins are related to the electrical connection of the LED chip 12. If the positive pin can be set at the most edge or the positive pin can be set between the plurality of the negative pins.

Referring to figs. 3 and 5, the conductive pattern 152 and the first conductor 142 or the second conductor 143 can be electrically conductive through a conductive through hole 16 through the carrier 11. The conductive through hole 16 can be formed by filling the through hole through the carrier 11 with conductive material. The specific number and position of the conductive through hole 16 shall be determined according to the circuit connection relationship of the light source assembly 10. The setting of the conductive through hole 16 can lead the conductive circuit of the solder pad pattern 141 on one side of the LED chip 12 to the opposite side of the LED chip 12, thus realizing that all the conductive circuits in the light source assembly 10 can be set in the positive projection area relative to the uniform layer 13, and further realizing the light source without or with narrow border. Display provides support. Further, the pad pattern 141, the first conductor 142, the second conductor 143, the pin 151 and the conductive pattern 152 are all arranged in the positive projection area of the fluorescent layer 131.

Among them, the number and position of the conductive through hole 16 are not limited, and only the control area can be operated normally. By partitioning the LED chip 12, the time-sharing and partitioning drive of the LED chip 12 can be further realized. Preferably, the pin 151 can be electrically connected through the conductive pattern 152, the conductive through hole 16 and the corresponding circuit area in turn.

In some more preferred embodiments of the invention, the conductive pattern 152 may be a metal layer directly formed on the carrier 12, which forms multiple regions by etching. An insulating layer is arranged above the metal layer to avoid interference between different conductive patterns 152. Furthermore, the metal layer arrangement can also provide heat dissipation for the heat generated during the operation of the LED chip 12, so as to avoid excessive temperature caused by the simultaneous luminescence of multiple LED chips 12, thereby prolonging the service life of the LED chip 12.

In conjunction with FIG. 5, the plurality of pins 151 may further include an A1 terminal and a K1-Kn terminal in the present invention. Among them, the K1 terminal and the Kn terminal correspond to the driving partitions of the plurality of LED chips 12. For example, in the light source component 10 with the size of 66mm^{∗}60mm, in order to make the light source component 10 have better luminous effect, the LED chip 12 can be divided into 32 regions, corresponding to the K1-K32 terminal. By connecting the A1 terminal and the K1 terminal to the K32 terminal through an external circuit, the partition control of the light source assembly 10 is realized.

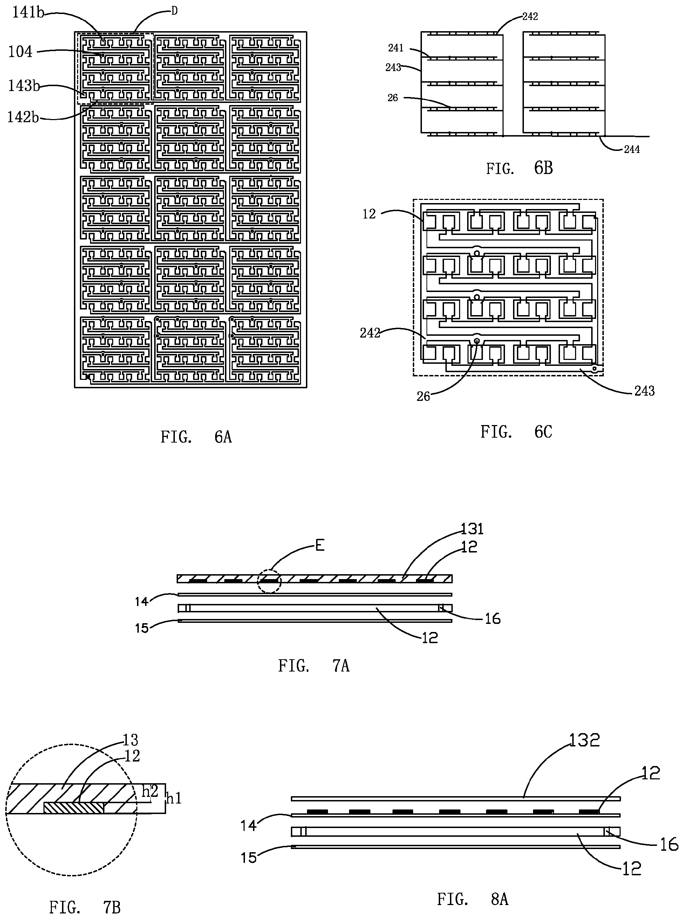

Please continue to refer to figs. 6A-6C. In one variant embodiment of this embodiment, the difference between a set of conductors 249 and the above-mentioned embodiments is that a set of conductors 249 consists of multiple first conductors 242, multiple second conductors 243 and bus 244 connecting multiple second conductors 243, in which the first conductor 242 and the second conductor 244 are shown in Fig. 5B. 43 are comb-shaped, and the first conductor 242 and the second conductor 243 are staggered. The same LED chip 22 is welded on two different pad patterns 241 adjacent to each other. One pad pattern 241 is connected to the first wire 242 and conducts electrically. The other pad pattern 241 is connected to the second wire 243 and conducts electrically.

The circuit connection relationship of the pad pattern 241 connected with the first conductor 242 and the second conductor 243 is as follows: one end of the pad pattern 241 connects the first conductor 242, the other end connects the positive pole of the LED chip 22; one end of the pad pattern 241 connects the second conductor 243, and the other end connects the negative pole of the LED chip 22.

In this deformation embodiment, two different pad patterns 241 corresponding to the same LED chip 22 are positioned on a set of pad patterns 240. The first wire 242 and the second wire 243 are arranged parallel on the comb line, and a plurality of pad patterns 240 are arranged side by side. Among them, a plurality of pad patterns 240 are distributed along the same straight line interval. Among them, as shown in Figure 6C, four sets of pad pattern groups 24 are arranged parallel between the comb shapes of the first conductor 242 and the second conductor 243.

Among them, the conductive through hole 26 may be arranged above the first conductor 242 or the second conductor 243.

In this deformable embodiment, 16 parallel LED chips can be formed into a control region. At least one conductive through hole 104 connected with positive conductor 151 is arranged on the first conductor 142, and at least one conductive through hole 104 connected with negative conductor 152 is arranged on the second conductor 143. Among them, the number and position of the conductive through hole 104 are not limited, and only the control area can be operated normally. By partitioning the LED chip 12, the time-sharing and partitioning drive of the LED chip 12 can be further realized.

In the present invention, the materials forming the first conductive layer 14 and the second conductive layer 15 may be copper, aluminium, gold, silver, nickel, zinc, ir Before welding the LED chip 12 on the solder pad pattern 141, steel screen printing is also needed on the first conductive layer. The purpose is to uniformly print solder paste on the corresponding solder pad pattern 141, and solidify the positive and negative poles of the LED chip on different solder paste soldering points by reflow soldering process. In order to place more LED chips on the carrier 11 and make the distance between adjacent LED chips smaller, nano-scale steel mesh is selected for printing in the present invention, and the particle size of the solder paste can be less than 30 micron.

The advantages of the above-mentioned settings are as follows: on the surface of the LED chip 12, the distance between the adjacent settings of the pad pattern 241 can be reduced by designing the pad pattern. Correspondingly, the size of the LED chip 12 can be further reduced, and the number of the LED chip 12 set in the unit area will correspond. Ground increase.

Please continue to refer to Fig. 7A. In the first concrete embodiment of the invention, the leveling layer 13 can be a fluorescent layer 131, which bases all the LED chips 12 and fills the gap between two adjacent LED chips 12. That is, all LED chips 12 are baseed by the same fluorescent layer 131. The fluorescent layer 131 integral moulding described herein and below is specifically expressed as: covering the solid state fluorescent layer 12 over the LED chip 12 and the carrier 11; hot pressing the fluorescent layer 12 to soften the fluorescent layer 12 and form the fluorescent layer 131, and the plurality of the LED chip 12 are encapsulated in the fluorescent layer 131. Internally, the required fluorescent layer 131 is obtained.

In some special embodiments, the fluorescent layer 12 undergoes a secondary hot pressing operation. The fluorescent layer 12 is softened by hot pressing and coated on the surface of the carrier 11 and the LED chip 12 fixed on the carrier 11, and the fluorescent layer 131 is also provided between the adjacent LED chips 12. This arrangement enables the light emitted by the LED chip 12 to cooperate with the light generated by the fluorescent substance in the fluorescent layer 131 to achieve a uniform luminous effect. Specifically, a plurality of the LED chips 12 are regularly fixed on the surface 1201 of the carrier 12. The fluorescent layer 131 matches the shape of the carrier 12 in the superposition direction and is formed on the surface of the carrier 12 fixed with the LED chip 12, so that the LED chip 12 is encapsulated in the fluorescent layer 131 to form a planar light source. In the present invention, the area of the fluorescent layer 131 is the same as that of the carrier 11.on, graphite materials or transparent conductive oxides.

Compared with the prior art, under the premise of the same area and the same number of LED chips, the light emitted by the light source unit 10 provided in the present embodiment has higher light efficiency, higher light utilization rate and more uniform brightness.

As shown in Fig. 7B, in order to make the light source assembly 10 have better luminous efficiency, the distance HI between the main surface 1201 of the LED chip 12 and the main luminous surface 1311 of the fluorescent layer 131 is the minimum thickness HI of the fluorescent layer 131. The distance between the surface 1101 of carrier 11 with LED chip 12 and the main luminous surface 1311 of fluorescent layer 131 is the maximum thickness H2 of fluorescent layer 131. In some preferable embodiments of the invention, the minimum thickness HI of the fluorescent layer 131 covering the LED chip 12 is 0.003mm-0.191mm, and the maximum thickness H2 of the fluorescent layer 131 is 0.004mm-0.2mm. In the present invention, the thickness of the fluorescent layer 131 is adjusted according to the requirement of the luminous intensity of the light source component 10. Preferably, in order to make the luminous intensity uniform, the minimum thickness HI of the fluorescent layer 131 can be 0.08-0.12mm, and the maximum thickness H2 of the fluorescent layer 131 can be 0.15-0.3mm.

Further, according to the size requirements of the LED chip 12, the minimum thickness HI of the fluorescent layer 131 can be 0.003mm, 0.006mm, 0.009mm, 0.01mm, 0.03mm, 0.035mm, 0.05mm, 0.07mm, 0.10mm, 0.12mm, 0.15mm or 0.191mm, and the maximum thickness H2 of the fluorescent layer 131 can be specified as 0.004mm, 0.006mm, 0.01mm, 0.191mm. 03mm, 0.07mm, 0.09mm, 0.1mm, 0.11mm, 0.13mm, 0.15mm, 0.17mm, 0.19mm or 0.2mm,

In the present invention, in order for the fluorescent layer 131 to effectively homogenize the light emitted by all the LED chips 12 under its base, the minimum thickness HI of the fluorescent layer 131 needs to be positively correlated with the spacing between the adjacent LED chips 12. The smaller the spacing between the adjacent LED chips 12 is, the smallest the corresponding fluorescent layer 131 is. The smaller the small thickness of h1, and the larger the distance between adjacent LED chips 12, the larger the minimum thickness of the corresponding fluorescent layer 131. Specifically, when the spacing e between the two LED chips 12 is 0.1mm-1mm, the minimum thickness H2 of the corresponding fluorescent layer 131 is 0.1mm-0.2mm. When the spacing e between the two LED chips 12 is 0.01-0.1 mm, the minimum thickness H2 of the corresponding fluorescent layer 131 is further 0.01-0.05 mm.

Further, the maximum thickness H2 of the fluorescent layer 131 should be at least greater than the thickness of the LED chip 12.

Further, in order to make the light source component 10 have better luminous effect and avoid the problem of uneven luminous emission at the edge of the LED chip 12, the distance between any edge of the fluorescent layer 131 and the edge of the LED chip 12 closest to the edge is 0.002mm-0.1mm, preferably the distance can be further 0.00 mm. 2 mm-0.001 mm, 0.001 mm-0.004 mm, 0.004-0.006 mm, 0.007-0.01 mm, 0.01-0.03 mm or 0.03-0.1 mm.

Furthermore, in order to achieve better luminous effect of the light source component 10, the ratio between the length of the LED chip 12 and the distance mentioned above needs to satisfy a certain proportion range.

Further, in order to obtain better luminescence effect of the light source assembly 10, in some specific embodiments of the invention, the fluorescent layer 12 includes a fluorescent powder composition, a colloid and a diffusion particle.

The LED chip 12 is a blue light chip or a near ultraviolet light chip.

The phosphor composition may include but is not limited to: red phosphor: one or more of nitrogen oxides, fluorides, nitrides, etc; green phosphor: one or more of theron, silicate, etc; yellow powder: one or more of yttrium aluminate garnet, silicate, etc; blue powder: one or more of barium aluminate, aluminate, etc. Species.

The colloids may include but are not limited to: organic silica gel and inorganic silica gel, in which the organic silica gel includes one or several mixtures of silicone rubber, silicone resin and silicone oil, and the inorganic silica gel includes one or several mixtures of B-type silica gel, coarse porous silica gel and fine porous silica gel.

The diffused particles are one or several combinations of silica, organosilicon, acrylic acid or calcium carbonate, in which the diameter of the diffused particles is 7-20 um. The particle size and quantity of the diffused particles can improve the deflection and diffusion effect of the light source of the fluorescent layer 131, and at the same time improve the Polish and transmittance of the fluorescent layer 131. More optimally, in order to obtain better mixing effect, the diffused particles can be combined with at least two particles with different refractive index of light.

Among them, the quality of the fluorescent powder composition accounts for 30% to 50% of the total mass of the fluorescent glue composition and the colloid.

In some preferred embodiments of the invention, the phosphor composition includes yellow phosphor, i.e., one or two mixtures of yttrium aluminium garnet, silicate and the like. The LED chip 12 is preferred to be a blue chip. In the fluorescent layer 131, the LED chip 12 emits blue light and excites the place. The yellow powder in the phosphor composition emits yellow light. In the light source assembly 10, the light emitted by the LED chip 12 and the light emitted by the phosphor are diffused in the fluorescent layer 131 to form a white light with uniform brightness.

In some other embodiments of the invention, the phosphor composition may also include a combination of red phosphor and green phosphor, i.e., the red phosphor in the phosphor composition may include one or more nitrogen oxides, fluorides, nitrides, etc., and one or more green phosphors, including salons, silicates, etc. The LED chip 12 is further preferred to be a blue chip.

In some preferred embodiments of the invention, the fluorescent layer composition includes a combination of red phosphor, green phosphor and yellow phosphor, the red phosphor includes one or more nitrogen oxides, fluorides, nitrides, etc., and the green phosphor includes halosilicates, sulfides, silicates and nitrogen oxides. One or more combinations; yellow phosphor: yttrium aluminium garnet, silicate, etc. The LED chip 12 is further preferred to be a blue chip.

Further, the red phosphor is one or combination of potassium fluosilicate and potassium fluorogermanate, the green phosphor is salon, and the yellow phosphor is one or several combinations of strontium silicate, magnesium silicate and barium strontium silicate.

Further, the fluorescent layer composition comprises a red phosphor, a green phosphor and a yellow phosphor with a mass ratio of (1-4): (0.5-2): (0.5-2).

Furthermore, the mass ratio of red phosphor, green phosphor and yellow phosphor is (1-3): (0.5-1.5): (0.5-1.5).

In some specific embodiments of the invention, the red phosphor is potassium fluorogermanate, the yellow phosphor is silicate, and the green phosphor is cylon. The quality of the red phosphor, the green phosphor and the yellow phosphor can be 64%, 16% and 20% of the total phosphor, respectively. The quality of the red phosphor, green phosphor and yellow phosphor accounted for 58.4%, 17.2% and 24.4% of the total phosphor, respectively. The quality of the red phosphor, the green phosphor and the yellow phosphor accounted for 68%, 14% and 18% of the total phosphor, respectively. The quality of the red phosphor, the green phosphor and the yellow phosphor accounted for 52%, 22% and 26% of the total phosphor, respectively.

Preferably, the red phosphor, green phosphor and yellow phosphor accounted for 60%, 18% and 22% of the total phosphor, respectively.

In other embodiments of the invention, the red phosphor is potassium fluosilicate, the yellow phosphor is yttrium aluminium garnet, and the green phosphor is cylon. The quality of the red phosphor, the green phosphor and the yellow phosphor can account for 61.2%, 19.4% and 19.4% of the total phosphor, respectively. The quality of the red phosphor, the green phosphor and the yellow phosphor accounted for 58%, 21% and 21% of the total phosphor, respectively. The quality of the red phosphor, the green phosphor and the yellow phosphor accounted for 55%, 23% and 22% of the total phosphor, respectively. The quality of the red phosphor, the green phosphor and the yellow phosphor accounted for 67%, 17% and 16% of the total phosphor, respectively.

Preferably, the red phosphor, green phosphor and yellow phosphor accounted for 60%, 20% and 20% of the total phosphor, respectively.

In order to make the carrier 11 and the fluorescent layer 131 more closely adhere to each other, and the phenomenon of glue opening does not occur due to bending. The deflection between the fluorescent layer 131 and the carrier 11 shall be substantially the same. Therefore, when selecting the material of the carrier 11, it is necessary to select the material of the fluorescent layer 131 together.

Referring to Fig. 8A, in the second specific embodiment of the present invention, the uniform layer 13 may be an optical diaphragm 132, and the optical diaphragm 131 may be one or more of diffusion or brightening films, etc. The specific embodiment differs from the prior art in that the LED chip 12 is directly attached to the optical diaphragm 131 without gap, thereby further reducing the overall thickness of the light source assembly 10.

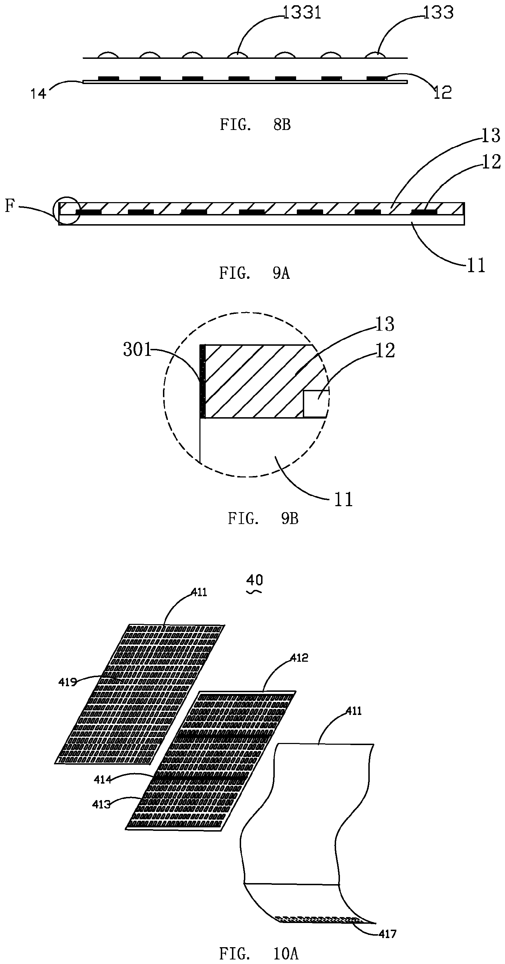

As shown in Fig. 8B, in some special embodiments of the invention, the leveling layer 13 can further be a microlens layer 133, which is provided with a plurality of microlenses 1331 corresponding to the LED chip 12. The light emitted by the LED chip 12 enters the microlens 1331, realizing optical refraction and reflection, thereby achieving the effect of uniform light. The thickness of the microlens layer 133 and the size and distribution position of the single microlens 1331 are related to the distribution of the LED chip 12.

In the third specific embodiment of the invention, the leveling layer 13 is a combination of the fluorescent layer 131 and the optical diaphragm 132, which can be realized by covering the fluorescent layer 131 directly over all the LED chips 12 and filling the gap between the LED chips 12, and the optical diaphragm 132 directly above the fluorescent layer 131.

In some special embodiments of the present invention, the method can also be realized by directly attaching the optical diaphragm 13 on the LED chip 12, and then forming a fluorescent layer 131 on the side of the optical diaphragm 13 far from the LED chip 12.

In some special embodiments of the invention, the microlens 133 can be directly attached to the fluorescent layer 131 covering the LED chip 12, thereby further enhancing the uniformity of light emitted by the light source assembly 10.

In the present invention, the combination mode of the specific layer structure of the leveling layer 13 can be adjusted according to the required luminous effect of the light source component 10 and the specific distribution mode of the LED chip 12, and different combination modes can achieve different luminous effects.

In the above-mentioned embodiments of the invention, the thickness of the light source assembly 10 can be 0.06mm-1 mm. Preferably, the thickness of the light source component 10 is 0.06mm-0.1mm, 0.1mm-0.5mm, 0.2mm-0.8mm or 0.8-1mm, and the thickness of the light source component 10 is 0.06mm, 0.1mm, 0.127mm, 0.254mm, 0.35mm, 0.5mm, 0.8mm or 1mm.

Referring to figs. 9A and 9B, in another deformed embodiment of the present invention, the light source assembly 11 further includes a white edge 301 formed on the carrier 11 and arranged around the fluorescent layer 131. The outer periphery of the white edge 301 corresponds to the area of the carrier 11.

In the present invention, the white edge 301 is formed on the side of the fluorescent layer 131 by coating or coating after the formation of the fluorescent layer 131. By cutting, the white edge 301 can have a thinner thickness while reflecting the side of the fluorescent layer 131. The edge of the luminous surface of the fluorescent layer 131 in the light source device 10 is basically the same as that of the side of the carrier 11 with the LED chip 12.

The LED chip 12 excites the light emitted from the fluorescent layer 131 to the side, which is reflected by the white edge 301 and emitted at an angle through the fluorescent surface 1101 of the fluorescent layer 111. In the present invention, the white edge 301 can be used to reflect the light emitted from the LED chip 12 to the side and emit the light source assembly 10 at an angle through the light emitting surface 1101 of the fluorescent layer 131, thereby realizing the effective utilization of the light source.

In the present invention, the thickness of the white edge 301 is 0.001mm-0.1mm, and further, the thickness of the white edge 301 can be 0.001mm-0.01mm, 0.002mm-0.008mm or 0.01mm-0.09mm. In some specific embodiments of the invention, the thickness of the white edge 301 can be specified as 0.001 mm, 0.002 mm, 0.05 mm, 0.1 mm, etc. The foregoing is merely an example, not a limitation of the present invention.

Referring to Fig. 10A, the second embodiment of the present invention provides another light source component 40, which comprises a carrier 41 and a plurality of LED chips 42. The carrier 41 comprises a two-layer layer 411 superimposed on each other, and a conductive layer 412 between the two layers 411. The conductive layer 412 comprises a plurality of pad patterns 413 and a pad pattern 413. There is an electrical connection between wires 414, in which a layer of film 411 is provided with a plurality of windows 419 that expose the corresponding pad pattern 413.

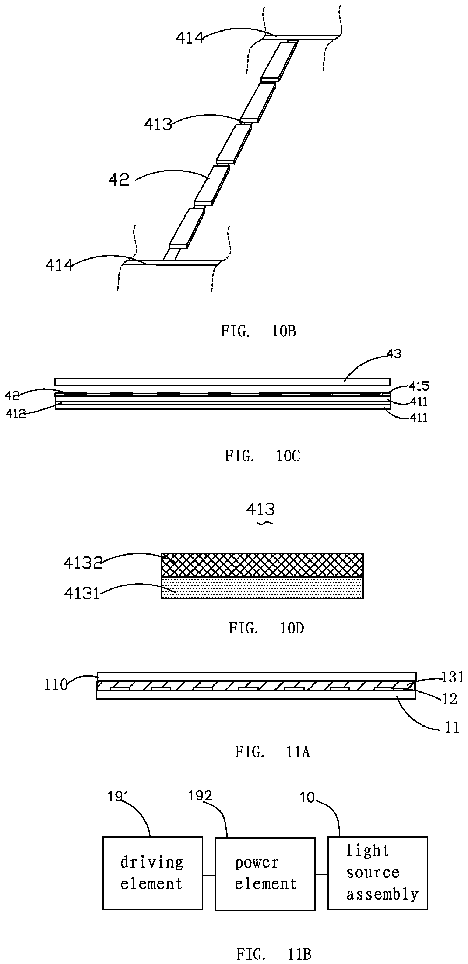

Continue to combine the positive and negative electrodes of the LED chip 42 as shown in Figure 10B and Figure 10C. The positive and negative electrodes of the LED chip 42 are soldered on different solder pad patterns 413 by solder paste soldering respectively. The light source component 40 also includes a fluorescent layer 43, which fills the gap between the LED chip 42 and bases all the LED chips 42.

The membrane 411 may be preferred as a flexible material, and the material of the membrane 411 may include, but is not limited to, any of the polyimides, polyethylene terephthalate, aromatic amide fiber esters or polyvinyl chloride.

Continuing as shown in Fig. 10C, in order to improve the brightness and uniformity of the light source component 40, and to avoid dark areas in the light source component 40, a reflective layer 415 can be further baseed on the film 411 with a window 419, and the reflective layer 415 is located at the non-window of the film layer. Preferably, the reflector 415

As shown in Fig. 10D, the solder pad pattern 413 can specifically include a copper foil layer 4131 and a silver plated layer 4132 on the copper foil layer 4131. The copper foil layer 4131 can act as a conductive layer and can electrically conduct the LED chip 42 and the conductor 414 soldered on the solder pad pattern 413. The setting of silver plating layer 4132 can further improve the luminous effect of the solder pad pattern 413 on the light emitted by the LED chip 42, thereby enhancing the light efficiency of the light source component 40.

Preferably, the reflector 415 is one or more combinations of white oil layer, aluminum foil reflector layer or silver reflector layer.

Please continue to refer to Fig. 10A. The light source assembly 40 also includes pins 417 connected to peripheral circuits, which are set in the same layer with conductive layer 412 or stacked with conductive layer 412. Since the film 411 is a flexible foldable material, it can be folded into the orthographic projection area of the conductive layer 412 for opening window 419, so that the luminous area of the light source assembly 40 can be consistent with the overall area of the carrier 41.

In some better embodiments of the present embodiment, in order to obtain better luminescence effect, the LED chip 42 can be arranged in an array pattern, and the distance between two adjacent LED chips 42 is 0.01 mm-1 mm.

In order to obtain better luminous effect, the light source component 40 and the single LED chip 42 are rectangular, the long edge of the light source component 40 is parallel to the long edge of the LED chip 42, the short edge of the light source component 40 is parallel to the short edge of the LED chip 42, and the length of the LED chip 42 is 0.01 mm-1 mm, and the LED core is parallel. The width of chip 42 is 0.01mm-0.5mm.

Among them, the specific parameters of the length, width and distribution spacing of the LED chip 42 are consistent with those in the first embodiment mentioned above, and will not be repeated here.

Referring to Fig. 11A, the third embodiment of the present invention provides a display device 100 comprising a light source assembly 10 with a continuous light emitting surface and a display unit 110, the light emitting surface of the light source assembly 10 is seamless with the display unit 110.

In some preferred embodiments, the side of the fluorescent layer 131 away from the carrier 11 is the luminous side of the light source assembly 10. The luminous surface of the fluorescent layer 131 is seamlessly fitted with the display device 110. In the present embodiment, the edge of the carrier is even at the edge of the display component. Further, the area of the fluorescent layer 131 is the same as that of the carrier 11.

As shown in Fig. 11B, preferably, the display device 100 further includes power supply unit 192 and drive unit 191, which can be used to provide control signals for the light source unit 10 so that the light source unit 10 can realize subregional lighting; and the power supply unit 192 is used to provide power supply for the light source unit 10. The drive unit 191 can also control the start or shutdown of the power supply unit 192, and further control the output power of the power supply unit 192.

The driving device 191 is connected with pins (151 or 417) to drive and control the LED chip in a partition.

Specifically, in some preferred embodiments of the present invention, the control component 192 drives multiple said LED chips 12 in the light source assembly 10 in a dynamic backlight driving mode.

In the present invention, the display module 109 may provide a display device requiring backlight, including but not limited to: a DSTN-LCD display (Dual Scan Tortuosity Nomograph-Liquid Crystal Display, double-layer supertwisted nematic liquid crystal display), a TFT-LCD display (thin film Transistor-Liquid Crystal Display, thin Membrane transistor liquid crystal display, etc. It should be noted in particular that the types of display elements 109 listed above are only illustrative, and are not constraints on the types of display elements 109 in the present invention.

The edge frame of the light source assembly 10 corresponds to the position of the edge of the display area of the display component. Further, the ratio between the area of the display area of the display device 110 and the area of the luminous surface of the fluorescent layer 131 is 1:(0.9-1.1). Preferably, the ratio between the area of the display area of the display unit 110 and the area of the luminous surface of the fluorescent layer 131 is further 1:(0.95-1.05). Better yet, the ratio between the area of the display area of the display device 110 and the area of the luminous surface of the fluorescent layer 131 is 1:1. That is to say, the area of the luminous surface of the fluorescent layer 131 is the same as that of the carrier 11 with the LED chip 12.

The light source component 10 included in the display device 100 of the present invention has all the technical features included in the first and second embodiments as described above, and the same part thereof will not be repeated here.

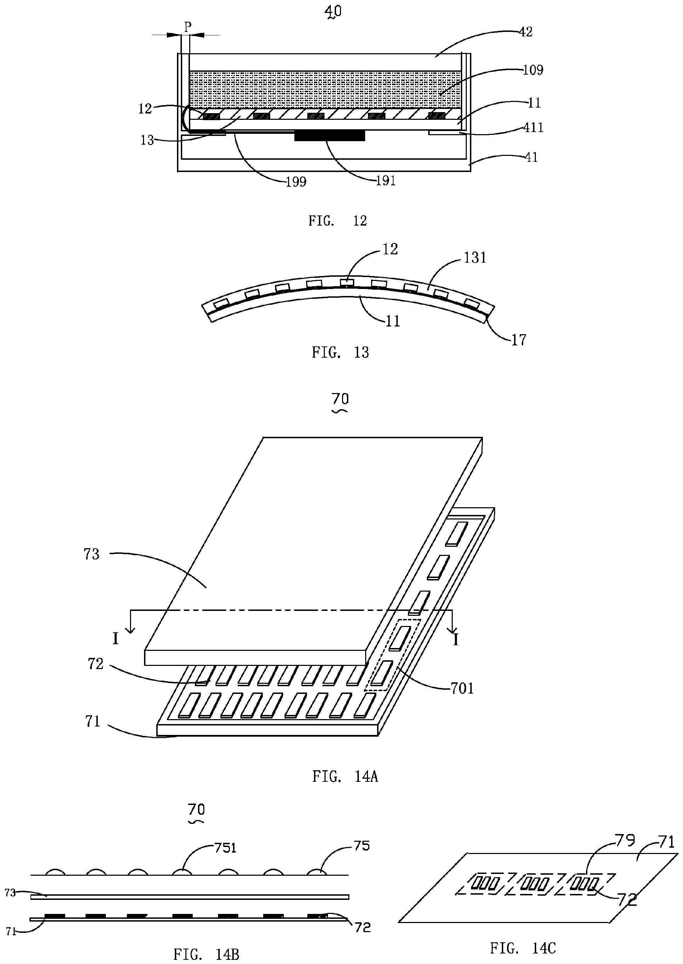

Referring to Fig. 12, the fourth embodiment of the present invention provides an electronic device 40 comprising a support 41 with a cavity that can accommodate the display device 100 described in the second embodiment of the appeal. The user-oriented side of the display device 100 is also provided with a protective base 42.

The support 41 further comprises a convex 411 symmetrically arranged on the side wall of the support 41, which can provide support for the display device 100. The protrusion 411 further forms an internal space in the display device 100. In order to make full use of the internal space of the electronic device 40 and avoid the excessive volume of the electronic device 40, thereby reducing the portability of the electronic device 40, the internal devices such as the power supply unit 192, the driver chip 191 and so on can be arranged in the internal space.

As shown in the figure, in order to further increase the screen proportion of the display area described in the electronic device 40, the display unit 109 in the display device 100 is electrically connected with the driving chip 191 through the flexible circuit board 199. Because the flexible circuit board 199 has better flexibility, the side wall of the support 41 is connected with the driving chip 191. The distance P of the side face of the display device 100 is negligible.

Different from the existing electronic equipment, the display device 100 and the support 41 in the electronic equipment 40 provided by the present invention are independent of each other in display function. Therefore, the support 41 only supports the carrier 11 without affecting the display effect of the display device 100. The support 41 will not affect the luminous effect of the light source assembly 10.

In order to maintain a good luminous effect after local bending of the light source assembly 10, the light source assembly 10 needs to satisfy the above distribution density requirements.

As shown in Fig. 13, the carrier 11 may be a flexible carrier. In the present embodiment, when the light source component 10 is bent as a whole, the carrier 11 is bent with a certain radian under stress. During the bending process, the fluorescent layer 131 is always attached to one side of the carrier 11 fixed with the LED chip 12. The fluorescent layer 131 gradually bends along the bending direction of the carrier 11, and the curvature of the fluorescent layer 131 matches the curvature of the carrier 11. That is, the deflection of the fluorescent layer 131 and the carrier 11 are basically the same. Deflection refers to the displacement of the center of cross section along the line perpendicular to the axis during bending deformation.

In some preferable embodiments of the invention, the deflection of the reflective film 17 is consistent with that of the carrier 11 and the uniform layer 13.

In the present embodiment, the electronic device 40 includes the light source assembly 10 described in any of the above-mentioned embodiments. The light source component 10 provided by the present invention does not generate dark areas in the edge area of the display module of the electronic device 40 compared with the side light source or the straight down light source commonly used in the prior art, so it can be made into an electronic device 40 without or with narrow borders.

Further, in some other embodiments of the invention, the electronic device 40 may not set a frame to accommodate the display device 100, and the driver chip 191 and the power supply assembly 192 may be set on the side of the display device 100 to obtain a thinner electronic device.

Further, in some special embodiments of the invention, the electronic device 40 may be an electronic device 40A of a flexible display component. By choosing the flexible, foldable or curled carrier, the light source assembly 10A with flexibility can be obtained, and an electronic device with flexible display components can be prepared.

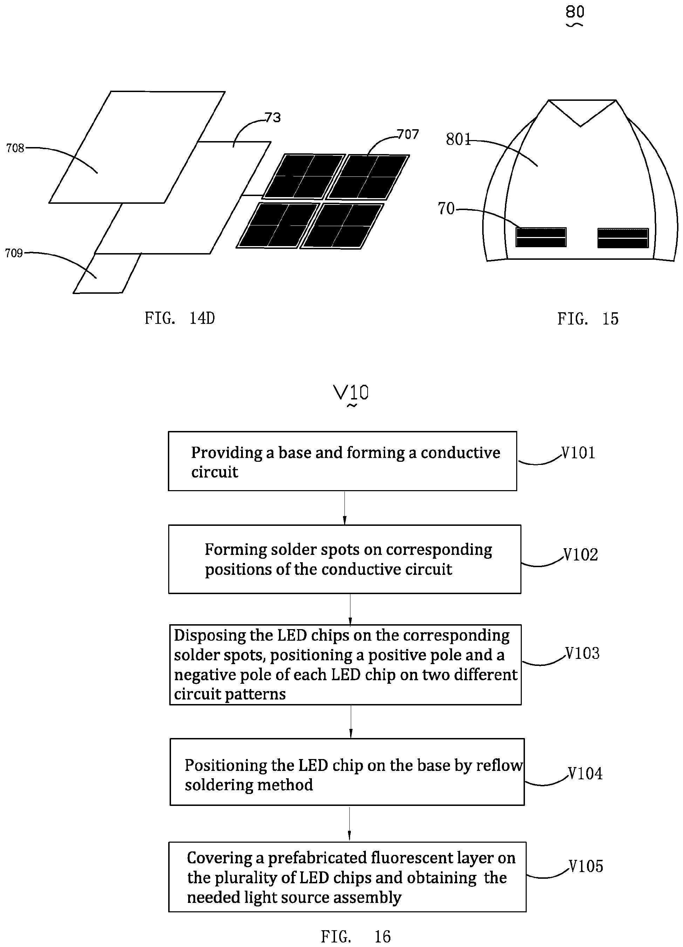

Referring to Fig. 14A, in the fifth embodiment of the present invention, a novel display device 70 is provided, which comprises a carrier 71, a plurality of LED chips 72 arranged on the carrier 71, a driving circuit 79, a fluorescent layer 73 covering the LED chip 72 and the carrier 71. The plurality of LED chips 72 are defined as multiple regions 701, and LE in the plurality of regions 701. The D chip 72 is driven and controlled by the driving circuit 79 partition for displaying images, and the light emitted by the plurality of the LED chips 72 is evened by the same fluorescent layer 73 to form a luminous surface 731.

The display device 70 is flexible and foldable; the single zone 701 includes one or more LED chips 72, and the LED chips 72 in the same zone 701 are synchronously driven.

The distance between two adjacent LED chips 72 is 0.01mm-0.75mm, the LED chip 72 is rectangular, the length of the LED chip 72 is 0.01mm-1mm, and the width of the LED chip 72 is 0.01mm-0.5mm.

As shown in Fig. 144, a microlens layer 75 is directly attached to the fluorescent layer 73. The microlens layer 75 is provided with a plurality of microlenses 75 corresponding to the LED chip 72.

Continuing as shown in Figure 14C, the display device 70 defines multiple pixels 79 with array arrangement, each pixel 79 corresponds to a single LED chip 72 or each pixel 79 corresponds to three LED chips 72 and the three LED chips 72 have different luminous colors. Preferably, the color of three LED chips 72 can be near ultraviolet and blue light. Best of all, the three LED chips 72 have three primary colors.

The LED chip 72 array arrangement comprises a plurality of TFTs arranged in the array, a plurality of first driving lines and a plurality of second driving lines. Each LED chip is connected to the drain of TFT, the gate line of TFT connected to the LED chip is connected to the first driving line, and the source line of TFT connected to the LED chip is connected to the second driving line. The gate of TFT connected by the same row of LED chips is connected to the first drive line of the same article, the gate of TFT connected by different rows of LED chips is connected to different first drive lines, the source of TFT connected by the same row of LED chips is connected to the second drive line of the same article, and the TFT connected by different rows of LED chips is connected to the second drive line of the same article. The gate is connected to different second drive lines.

In the present embodiment, the relevant restrictions for the elements of carrier 71, pad pattern 7121, wire 7122 in the display device 70 are consistent with those in the light source components, display devices and electronic devices in the first to fourth embodiments described above, and are not specified here. The main contents are as follows:
The carrier 71 comprises two relatively arranged sides, one of which is an array with a plurality of LED chips 72 and a fluorescent layer 73; the other side is provided with a plurality of pins for connecting with an external circuit, and the pins are electrically connected with the LED chip 72.

Further, in some other embodiments of the invention, the electronic device 40 may not set a frame to accommodate the display device 100, and the driver chip 191 and the power supply assembly 192 may be set on the side of the display device 100 to obtain a thinner electronic device.

Further, in some special embodiments of the invention, the electronic device 40 may be an electronic device 40A of a flexible display component. By choosing the flexible, foldable or curled carrier, the light source assembly 10A with flexibility can be obtained, and an electronic device with flexible display components can be prepared.

Referring to Fig. 14A, in the fifth embodiment of the present invention, a novel display device 70 is provided, which comprises a carrier 71, a plurality of LED chips 72 arranged on the carrier 71, a driving circuit 79, a fluorescent layer 73 covering the LED chip 72 and the carrier 71. The plurality of LED chips 72 are defined as multiple regions 701, and LE in the plurality of regions 701. The D chip 72 is driven and controlled by the driving circuit 79 partition for displaying images, and the light emitted by the plurality of the LED chips 72 is evened by the same fluorescent layer 73 to form a luminous surface 731.

The display device 70 is flexible and foldable; the single zone 701 includes one or more LED chips 72, and the LED chips 72 in the same zone 701 are synchronously driven.

The distance between two adjacent LED chips 72 is 0.01mm-0.75mm, the LED chip 72 is rectangular, the length of the LED chip 72 is 0.01mm-1mm, and the width of the LED chip 72 is 0.01mm-0.5mm.

As shown in Fig. 144, a microlens layer 75 is directly attached to the fluorescent layer 73. The microlens layer 75 is provided with a plurality of microlenses 75 corresponding to the LED chip 72.

Continuing as shown in Figure 14C, the display device 70 defines multiple pixels 79 with array arrangement, each pixel 79 corresponds to a single LED chip 72 or each pixel 79 corresponds to three LED chips 72 and the three LED chips 72 have different luminous colors. Preferably, the color of three LED chips 72 can be near ultraviolet and blue light. Best of all, the three LED chips 72 have three primary colors.

The LED chip 72 array arrangement comprises a plurality of TFTs arranged in the array, a plurality of first driving lines and a plurality of second driving lines. Each LED chip is connected to the drain of TFT, the gate line of TFT connected to the LED chip is connected to the first driving line, and the source line of TFT connected to the LED chip is connected to the second driving line. The gate of TFT connected by the same row of LED chips is connected to the first drive line of the same article, the gate of TFT connected by different rows of LED chips is connected to different first drive lines, the source of TFT connected by the same row of LED chips is connected to the second drive line of the same article, and the TFT connected by different rows of LED chips is connected to the second drive line of the same article. The gate is connected to different second drive lines.

In the present embodiment, the relevant restrictions for the elements of carrier 71, pad pattern 7121, wire 7122 in the display device 70 are consistent with those in the light source components, display devices and electronic devices in the first to fourth embodiments described above, and are not specified here. The main contents are as follows:
The carrier 71 comprises two relatively arranged sides, one of which is an array with a plurality of LED chips 72 and a fluorescent layer 73; the other side is provided with a plurality of pins for connecting with an external circuit, and the pins are electrically connected with the LED chip 72.

In some preferred embodiments of the invention, the step V102 may further be:
The solder paste is printed on the corresponding position of the first conductive layer to form solder joints through steel screen printing. Specifically, solder paste is printed on the carrier with solder disk pattern by using a solder paste machine, so that the solder paste is coated on the solder joints.

In some preferred embodiments of the invention, the step V104 may further be
The LED chip is further fixed on the carrier by reflow soldering. The nitrogen reflux furnace is used to further fix the LED chip. The oxygen content of the chip is less than 500 ppm, the reflux efficiency is 200 K/H, the solder paste temperature of the low temperature solder paste of the LED chip is 200 C, and the solder paste temperature of the high temperature is 260 C.

After step V104 above and before step V105, further steps may be included:
Step V106, a reflective film is placed on one side of the carrier with an LED chip. The reflective film is provided with a window corresponding to the position and number of the LED chip, through which the LED chip can be exposed. The reflective film can be used to uniformly reflect the disbasey of the LED chip, thereby enhancing the light efficiency of the light source assembly.

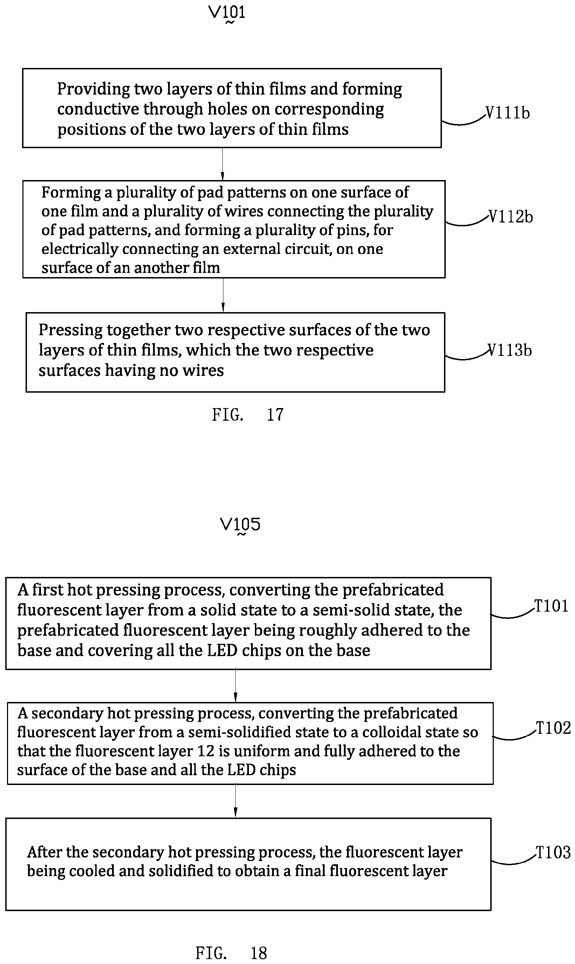

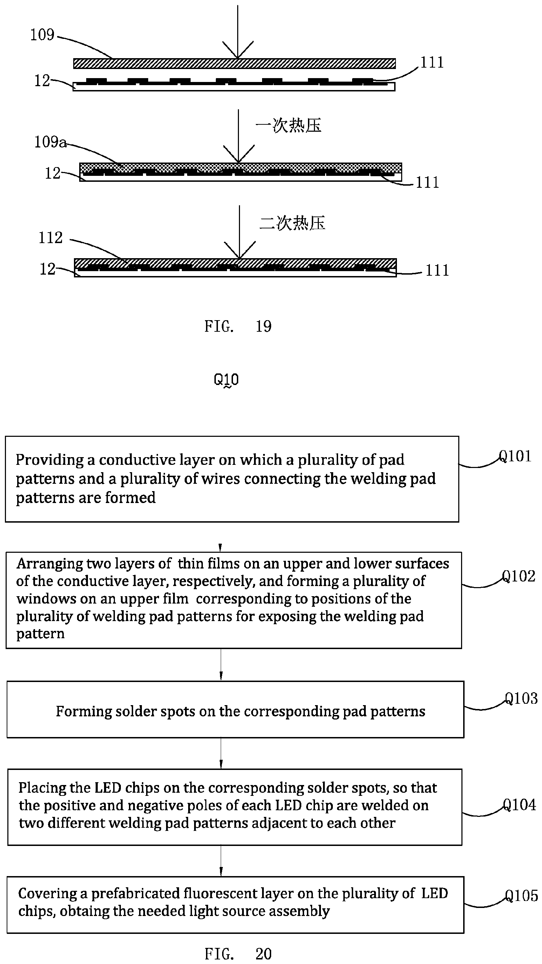

Continue with figs. 18 and 19. In step V105 above, the fluorescent film is heated to soften the prefabricated fluorescent film and form a fluorescent layer 131. The steps include:
Step T101, a hot pressing process is used to convert the fluorescent layer 12 from a solid state to a semi-solid state. The fluorescent layer 12 is roughly adhered to the carrier surface and coated with all the LED chips 12.

Step T102, a second hot pressing process is used to convert the fluorescent layer 12 from a semi-solidified state to a colloidal state so that the fluorescent layer 12 is uniform and fully adhered to the surface of the carrier 11 and the LED chip 12.

Step T103, after secondary hot pressing, the fluorescent layer 12 is cooled and solidified to obtain the required fluorescent layer 131.

In this embodiment, the fluorescent layer is formed on the main surface of a plurality of the LED chips fixed on the carrier by a hot pressing process. The fluorescent layer bases all LED chips fixed on the carrier. Unlike the existing technology in which the fluorescent glue bases a single LED chip, the fluorescent layer bases the LED chip, which can make the light emitting effect of the light source module more uniform.

Further, the temperature of the first hot pressing is 50-80 C, and the time of the first hot pressing is 10-20 min; the temperature of the second hot pressing is 120-180 C and the time of the hot pressing is 15-40 min; the first hot pressing and the second hot pressing are all carried out in an environment where the pressure is less than or equal to 10 torr.

In some better embodiments of the invention, in order to obtain the light source assembly 10 with better fitting effect, the time of hot pressing of the thermometer can be further limited. Specifically: the temperature of the first hot pressing is 57-63 C, and the time of the first hot pressing is 13-17 min; the temperature of the second hot pressing is 134-167 C, and the time of the hot pressing is 20-37 min; the first hot pressing and the second hot pressing are all carried out in an environment where the pressure is less than or equal to 7 torr.

In this embodiment, the LED chip is a blue light chip or a near ultraviolet light chip. The fluorescent layer includes a combination of yellow phosphor, red phosphor and green phosphor, and any combination of yellow phosphor, red phosphor and green phosphor. Among them, in the combination of yellow phosphor, red phosphor and green phosphor, in the combination of yellow phosphor, red phosphor and green phosphor, the selection and matching of specific phosphor, as described in the first embodiment of the present invention, will not be repeated here.

Referring to Fig. 20, according to the eighth embodiment of the present invention, a preparation method Q10 for a light source assembly is provided, which includes the following steps:
Step Q101 provides a conductive layer on which a plurality of pad patterns and a plurality of wires connecting the pad patterns are formed.

In step Q102, two layers of thin films are arranged on the upper and lower surfaces of the conductive layer, and a plurality of windows are formed on the corresponding pad positions of the upper and middle layers of thin films to expose the pad pattern.

Step Q103, solder spot is formed on the corresponding pattern of solder pad.

Step Q104, the LED chip is placed on the corresponding solder spot, so that the positive and negative poles of the LED chip are welded on two different pad patterns adjacent to each other.

Step Q105, after the same prefabricated fluorescent layer is formed by covering multiple LED chips, the required light source components are obtained.

In the present embodiment, the steps of forming solder joints, fixing LED chips and forming prefabricated fluorescent layer on the solder pad pattern formed by the conductive layer are consistent with those in the fifth embodiment described above, and will not be repeated here.

The preparation method of the light source assembly Q10 can prepare a flexible and foldable light source assembly.

In order to obtain light source components with smaller distribution density, it is further necessary to limit the spacing between pad patterns, i.e. the distribution density and wire width, so as to effectively place LED chips in a limited space to achieve uniform luminescence of light source components.

In the present invention, in order to further verify that the light source components and display devices provided by the present invention can obtain better luminous effect, the light source components provided by the present invention are compared with the existing light sources, in which the existing light sources include side-emitting light sources and straight-down light sources, based on the "LED" General Specification for Display Components SJ/T 11141-2003 tests the brightness, luminous efficiency and luminous flux of the light source components provided by the invention, the existing side-emitting light sources and the straight-down light sources respectively. The light source components provided by the invention, the existing side-emitting light sources and the straight-down light sources are all sampled. The number of LED chips with blue chips and yellow phosphors distributed along the main edge of the display module is the same. After the same power is put into the chip, the test is carried out and recorded.

The experimental results are shown in Table 1.

**Table 1. Experimental results of luminance, luminous efficiency and luminous flux of the light source assembly, the existing side light source and the downward light source provided by the invention.**

| | brightness(cd/m2) | Luminous efficiency (lm/W) | Luminous flux (lm) |
|---|---|---|---|
| Present invention | 10000 | 201.5 | 181 |
| side light source | 3000 | 72.1 | 40 |
| downward light source | 3800 | 73.5 | 52 |

Among the light source components provided by the invention, the LED chip is circular with a diameter of 0.01mm, the distance between two adjacent LED chips is 0.03mm, the minimum thickness of the fluorescent layer is 0.06mm, and the overall thickness of the light source component is 0.2mm. The total luminous area of the light source assembly is 66^{∗}60 mm, and 50 LED chips are arranged in each square millimeter.

The luminous areas of the three test groups were the same.

As can be seen from table 1, the brightness and light efficiency of the light source assembly provided by the invention can be increased by 1/3 compared with the existing light source, and the light flux of the light source assembly can be increased by 1.5 times compared with the existing light source.

For further verification, the luminous uniformity of the display device 100 described in the first embodiment of the present invention is further detected. The brightness uniformity of the three test groups was tested. The test method is as follows: multiple test points are selected, and the test points are evenly distributed in the luminous region. The brightness of multiple test points is detected and recorded.

The selection of test points needs to be adjusted according to the size of the display device which is actually tested. For example, six, nine, ten, 13 or 30 test points can be located according to the size of the display device.

By comparing the brightness of each test point obtained from the test, the brightness uniformity for the whole display device can be obtained.

Based on the above experiments, it can be seen that the light source assembly provided by the invention is superior to the existing side light source or the straight-down light source in terms of brightness, light efficiency, light flux and brightness uniformity.

Compared with the prior art, the light source assembly and its display device provided by the present invention have the following beneficial effects:
The invention provides a light source assembly, which comprises a continuous luminous surface formed by homogenizing the light emitted by a plurality of LED chips through the same fluorescent layer, and the area of the luminous surface is equal to that of one side of the fluorescent layer away from the LED chip; and the area of the luminous surface and one side of the carrier carrying the LED chip. The ratio is 1:(0.9-1.1). Compared with the traditional side-emitting light source component or the straight-down light-emitting component, the light source component provided by the invention realizes narrow or even no border, and the light source component has better light-emitting effect.

Furthermore, compared with the existing mainstream OLED screens, the light source components provided by the invention can be used in conjunction with the traditional LCD screens, providing a low-power, stable and uniform light-emitting backlight component, and providing an economical, high productivity, high quality rate and strong popularization alternative for large screen proportion display.

In the light source assembly provided by the invention, the film layer is a flexible material, and the film layer can be further optimized as a flexible material. The film layer is flexible and foldable, that is, the light source component made of the film can also be light, flexible and foldable. Therefore, the light source component can provide a variety of backlight and display effects for the display screen.

A single pad pattern can be composed of a copper foil layer and a silver plating layer arranged thereon, and the LED chip can be arranged above the silver plating layer. The copper foil layer can provide a stable and effective circuit connection relationship, and the setting of the silver plating layer can improve the optical reflectivity of the pad pattern, thereby avoiding the absorption of the copper foil layer in the pad pattern, resulting in dark areas in the display of the light source component, thereby further improving the uniformity of the light source component.

In order to further improve the luminous intensity of the light source assembly, a reflective layer can be formed at a non-window position on a thin film surface with an LED chip, and the reflective layer can be further white oil layer, aluminum foil reflective film layer or silver reflective film layer. The arrangement of the reflective layer can further improve the light emissivity of the film surface without windows, avoid the light source emitted by the LED chip being absorbed by the film layer, and produce dark areas. Furthermore, the setting of the white oil layer can further improve the overall luminous effect of the LED chip and improve the uniformity of the luminous.

In order to make the light source assembly suitable for display devices and electronic devices with more size requirements, the pins connecting the light source assembly with the external circuit can be further arranged on the same layer with the conductive layer or on the same layer with the conductive layer. If the film layer is thin, the pins can be folded through the film layer and arranged under the positive projection area of the conductive layer. Thus, the luminous surface of the light source assembly is consistent with the overall area of the carrier.

In the present invention, in order to achieve better luminous effect, the LED chips in the light source assembly are preferred to be array distribution. In order to make the thickness of the fluorescent layer correspondingly smaller, the distance between two adjacent LED chips can be 0.01mm-1mm, due to the thickness of the fluorescent layer and the distance between the two LED chips. Therefore, the thickness of the light source module can be further adjusted by adjusting the distance between the two LED chips to meet the requirement of light-thinning and uniform light efficiency.

Further, the long edge of the light source assembly is parallel to the long edge of the LED chip. The short edge of the light source assembly is parallel to the short edge of the LED chip, so that the luminous surface of the single LED chip matches the overall luminous surface of the light source assembly, thereby making full use of the luminous effect of the LED chip, so as to obtain more uniform. Luminescent effect. Furthermore, the size limitation of the LED chip can achieve better luminescence effect. At the same time, the LED chip can also be rationally utilized to reduce the use of the LED chip and the preparation cost of the light source component, thereby making the light source component provided by the invention more widely used.

The display device provided by the invention comprises a plurality of LED chips encapsulated in the same fluorescent layer to form a planar light source. In the present invention, one side of the fluorescent layer far from the carrier is equivalent to the display area of the display screen. The fluorescent layer is fitted with the display module without gap. Without setting a light guide plate and a reflector, the fluorescent layer has better luminous effect and can provide a uniform surface light source for the display screen. Furthermore, the fluorescent layer with conductive structure can be obtained without setting auxiliary structures such as enclosures, and the process steps can be simplified. The display device provided by the invention can be used as an alternative to OLED display screen, thereby providing a solution with high feasibility, low cost and high yield for obtaining a full-screen and lightweight display device and its electronic equipment.

In the display device provided by the invention, the LED chip is fixed on the carrier according to a certain arrangement law, and the carrier can be directly used as conductive material, that is, the carrier can be directly used as a flexible circuit board; furthermore, the solid state fluorescent film is baseed on the LED chip and the carrier by hot pressing; The fluorescent film softens the fluorescent film and forms a fluorescent layer. The LED chip in the light source assembly is encapsulated in the fluorescent layer. The light emitted by the LED chip and the fluorescent powder composition is stimulated to form uniform white light after diffusing. Therefore, there is no need to set a light guide plate and reflection. The light source assembly has simple structure and preparation process.

In addition, since all the LED chips are encapsulated in the same fluorescent layer, and the LED chips can achieve uniform luminescence and have a certain light refraction space, the LED chips and the diffuser are fitted without gap, thereby further reducing the thickness of the backlight module, simplifying the structure of the backlight module, and facilitating. The use and assembly of the backlight module.

The preparation method of the light source assembly provides a feasible method for preparing light source components with light thinning and uniform luminescence. The preparation method can form a solder pad pattern and solder spot on the carrier with two film layers, fix an LED chip on the solder spot and base a plurality of LED chips to form a fluorescent layer. In order to obtain flexible and foldable light source components, LED chips are directly formed on FPC. The method provided by the invention has high feasibility, low cost and high yield, and has great popularization value.

Further, by optimizing the substrate material in the light source assembly, the light source assembly provided by the invention can also be applied to a flexible display screen, and can provide a uniform light source for the flexible liquid crystal module while ensuring the quality and wide color display range of the display.

In the present invention, since there is no need to set the necessary light guide plate, reflecting plate, transmission plate, etc. in the existing light source, the light loss can be greatly reduced, and the power consumption of the light source assembly is much less than that of the existing technology under the condition of providing the same luminous brightness. The technology provided by the invention can improve the brightness of the light source component without increasing the power consumption. By adopting a new light source component, the power consumption and heat output of the electronic device can be greatly reduced, thereby improving the service performance of the electronic device.

The invention provides a light source assembly, the positive and negative poles of the LED chip are respectively welded on two pad patterns adjacent to each other, the wire connection connection part or all pad patterns; the positive projection area of a single LED chip is larger than or equal to the area occupied by two pad patterns corresponding to the LED chip, based on the above. The structure is limited, more LED chips can be installed on the same size carrier, and the distribution of LED chips can not be realized because of the pad pattern and wire settings, thus meeting the requirements of various luminous effects and uniformity. Compared with traditional side-emitting light source module or direct-down light-emitting module, its distribution density can be smaller, and the dark area will not appear because of the large distance between LED chips.

Furthermore, compared with the existing mainstream OLED screens, the light source components provided by the invention can be used in conjunction with the traditional LCD screens, providing a low-power, stable and uniform light-emitting backlight component, and providing an economical, high productivity, high quality rate and strong popularization alternative for large screen proportion display.

The display device provided by the invention comprises a plurality of LED chips encapsulated in the same fluorescent layer to form a planar light source. In the present invention, the side far from the carrier of the fluorescent layer is equivalent to the display area of the display module, and the fluorescent layer is fitted with the display module without gap. Without setting a light guide plate and a reflector, the fluorescent layer has better luminous effect and can provide a uniform surface light source for the display module.

In the light source component provided by the invention, the width of the LED chip is larger than the width of any of the pad patterns, thereby overcoming the problem of excessive spacing between the LED chips caused by excessive pad patterns in the prior art.

In order to obtain light source components with smaller distribution density, it is further necessary to limit the spacing between pad patterns, i.e. the distribution density and wire width, so as to effectively place LED chips in a limited space to achieve uniform luminescence of light source components.

In the present invention, according to the limitation of the connection relationship between the pad pattern and the wire, the circuit connection relationship of the LED chip can be adjusted to meet the demand of the voltage and current output of the light source component, so as to be better applied in various display devices and electronic devices.

A microlens layer can be directly attached to the fluorescent layer, and a plurality of microlenses corresponding to the LED chip are further arranged on the microlens layer. The setting of the microlens layer can further improve the uniformity and brightness of the light source module, thereby saving the use of the LED chip and the whole light source module. Body energy consumption.

The carrier can include two layers of flexible film superimposed, and there is a conductive layer between the two layers of flexible film. The conductive layer is composed of the plurality of solder patterns and a plurality of wires. The LED chip can be welded on the solder pattern. By setting a conductive layer between the two film layers, the overall thickness of the carrier can be further reduced, thereby further reducing the overall thickness of the light source assembly. Compared with the traditional side light source assembly or the straight-down light source assembly, the light source assembly provided by the present invention can realize the flexibility of the light source assembly while ensuring its luminous effect, thus cooperating with the preparation of narrow-frame or even no-frame display device.

Furthermore, compared with the existing mainstream OLED screens, the light source components provided by the invention can be used in conjunction with the traditional LCD screens, providing a low-power, stable and uniform light-emitting backlight component, and providing an economical, high productivity, high quality rate and strong popularization alternative for large screen proportion display.

The invention also provides a display device, which comprises a display component and the light source component, wherein the light source component can be directly attached to the display component. Compared with the existing display device, the thickness of the light source module is obviously smaller than that of the existing backlight module, and because the light source module is glowing in the front, the light source module has higher brightness and better uniformity than the existing backlight module.

The invention provides a display device, which comprises a fluorescent layer covering the LED chip and carrier. The plurality of LED chips are defined as a plurality of zones, and the LED chips in the plurality of zones are driven and controlled by the driving circuit for displaying images. The light emitted by the plurality of LED chips is homogenized by the same fluorescent layer. The resulting luminous surface. In the present invention, the LED chip can display the image directly. The display device can be used as an alternative to OLED display device, thus providing a solution with high feasibility, low cost and high yield for obtaining large screen and lightweight display device and its electronic equipment.

Further, the display device is further flexible and foldable, and a single area includes one or more LED chips, which are synchronously driven in the same area. The flexible foldable display device can expand the scope of use and the specific use scenario of the display device. In the same area, a single LED chip or all of the LED chips are driven at the same time, which can further improve the controllability and diversity of the direct display image of the LED chip.

The distance between two adjacent LED chips is 0.01mm-0.75mm, the LED chip is rectangular, the length of the LED chip is 0.01mm-1mm, and the width of the LED chip is 0.01mm-0.5mm. Compared with the existing LED display, the display device provided by the invention has larger display density and higher display precision, and the display device can be used as a display screen such as a handheld mobile device. Further, since the display device is glowing on the whole surface, the illumination uniformity of the display device is better than that of the existing display screen.

A microlens layer is attached to the fluorescent layer, thereby further improving the display brightness and display effect of the display device. The display device defines a plurality of pixels arranged in arrays, and each pixel can correspond to a single LED chip or three corresponding LED chips. In order to obtain the best display effect, the LED chip can be further driven as a pixel point to achieve a diversified display effect of the display device. In the present invention, each LED chip is connected to the drain of TFT, the gate line of TFT connected to the LED chip is connected to the first drive line, the source line of TFT connected to the LED chip is connected to the second drive line, and the gate of TFT connected to the same row of LED chips is connected to the first drive line of the same article, and the gate of TFT connected to different rows of LED chips is located. The gate of the connected TFT is connected to different first drive lines, the source of the TFT connected to the same row of LED chips is connected to the second drive line of the same article, and the gate of the TFT connected to different rows of LED chips is connected to different second drive lines. Through such connection settings, the effective control of the LED chip can be realized.

The carrier comprises two relatively arranged sides, one of which is an array with a plurality of LED chips and fluorescent layers; the other side is provided with a plurality of pins for connecting with an external circuit, and the pins are electrically connected with the LED chips. By leading the pin to the opposite side of the LED chip setting, a narrow frame or a borderless display device can be fabricated correspondingly.

The carrier can include two layers of flexible film superimposed, and there is a conductive layer between the two layers of flexible film. The conductive layer is composed of the plurality of solder patterns and a plurality of wires. The LED chip can be welded on the solder pattern. By setting a conductive layer between the two film layers, the overall thickness of the carrier can be further reduced, thereby further reducing the overall thickness of the light source assembly. Compared with the traditional side light source assembly or the straight-down light source assembly, the light source assembly provided by the present invention can realize the flexibility of the light source assembly while ensuring its luminous effect, thus cooperating with the preparation of narrow-frame or even no-frame display device.

Furthermore, compared with the existing mainstream OLED screens, the light source components provided by the invention can be used in conjunction with the traditional LCD screens, providing a low-power, stable and uniform light-emitting backlight component, and providing an economical, high productivity, high quality rate and strong popularization alternative for large screen proportion display.

The display device further includes a solar panel which provides power for the LED chip, thereby realizing self-luminescence of the display device, so as to make the display device have a wider application range.

The invention also provides a wearing device, which can be fixed on the main body of the wearing device. The main body of the wearing device includes clothes, hats, shoes, watches or schoolbags, etc. Because the display device is light and thin, it can be sewn directly on the main body of the wearing device.

Additional advantages and modifications will readily occur to those skilled in the art. Therefore, the invention in its broader aspects is not limited to the specific details and representative embodiments shown and described herein. Accordingly, various modifications may be made without departing from the spirit or scope of the general inventive concept as defined by the appended claims and their equivalents.

## Claims

1. Alight source assembly, comprises:
a base,
a plurality of LED chips disposed in an array on the base, and
a fluorescent layer covering the base and the plurality of LED chips;
wherein light from the plurality of chips is homogenized to form a light emitting surface by a same fluorescent layer; an area of the light emitting surface being equal to an area of one side of the fluorescent layer, far away of the plurality of LED chips; and the ratio of the area of the light emitting surface to an area of a side of the base, on which the plurality of LED chips being disposed, being 1:0.9 to 1:1.1.

2. The light source assembly as defined in claim 1, wherein the ratio of the area of the luminous surface of the fluorescent layer to the area of one side of the carrier carrying the LED chip is 1:1.

3. The light source assembly as defined in claim 1, wherein one to thirteen LED chips are arranged below each square millimeter corresponding to the fluorescent layer.

4. The light source assembly as defined in claim 1, wherein the distance between two adjacent LED chips is 0.01mm-1mm, the length of the chip is 0.01mm-1mm, and the width of the chip is 0.01mm-0.5mm. The thickness of the light source assembly is 0.01mm-0.6mm.

5. The light source assembly as defined in claim 1, wherein the carrier is provided with a plurality of pad patterns and a plurality of wires on one side of the LED chip, the positive and negative poles of the LED chip are respectively welded on two pad patterns adjacent to each other, and the connection of the wires or all of the pad patterns, and the positive projection area of a single LED chip is larger than or equal to two corresponding to the LED chip Area occupied by solder pad pattern.

6. The light source assembly as defined in claim 5, wherein one opposite side of the carrier and the LED chip, there are a plurality of pins for connecting with the external circuit, and the pins are electrically connected with the LED chip.

7. The light source assembly as defined in claim 1, wherein the carrier comprises two overlapping layers of film, and a conductive layer is arranged between the two layers of film. The conductive layer comprises a plurality of pad patterns, which are electrically connected through wires, a plurality of windows are arranged on one layer of film to expose the corresponding pad patterns, and the positive and negative poles of the LED chip correspond to tin soldering, and the light source assembly also includes a fluorescent layer which fills the gap between the LED chips and bases all the LED chips.

8. The light source assembly as defined in claim 1, wherein the light source assembly as defined in claim 1, wherein the film layer is a flexible material.

9. The light source assembly as defined in claim 5, wherein all pad patterns and wires are arranged in the orthographic projection area of the fluorescent layer.

10. The light source assembly as defined in claim 1, wherein the carrier is provided with a reflecting layer above one side of the LED chip and between the fluorescent layers. The reflecting layer is provided with multiple windows, and the LED chip is arranged in the window.

11. The light source assembly as defined in claim 1, wherein the light source assembly further comprises a white edge formed on the carrier and arranged around the fluorescent layer; the peripheral of the white edge is identical with the peripheral of the carrier; and the thickness of the white edge is 0.001 mm-0.1 mm.

12. The light source assembly as defined in claim 1, wherein a microlens layer is directly attached to the fluorescent layer, and a plurality of microlenses are arranged on the microlens layer corresponding to the LED chip.

13. A display device, comprise a display element and a light source assembly, the light source assembly comprises:
a base,
a plurality of LED chips disposed in an array on the base, and
a fluorescent layer covering the base and the plurality of LED chips;
wherein light from the plurality of chips is homogenized to form a light emitting surface by a same fluorescent layer; an area of the light emitting surface being equal to an area of one side of the fluorescent layer, far away of the plurality of LED chips; and the ratio of the area of the light emitting surface to an area of a side of the base, on which the plurality of LED chips being disposed, being 1:0.9 to 1:1.1.

14. A manufacturing method for light source assembly, comprise
providing a base and forming a conductive circuit;
forming solder spots on corresponding positions of the conductive circuit;
disposing the LED chips on the corresponding solder spots, positioning a positive pole and a negative pole of each LED chip on two different circuit patterns;
positioning the LED chip on the base by reflow soldering method; and
covering a prefabricated fluorescent layer on the plurality of LED chips and getting the needed light source assembly.
